# EUROPÄISCHE PATENTSCHRIFT

(11) **EP 0 885 455 B1**
(45) Veröffentlichungstag und Bekanntmachung des Hinweises auf die Patenterteilung: **21.07.2004**
(21) Anmeldenummer: 97906173.6
(22) Anmeldetag: 03.03.1997
(51) Int. Cl.: H01J 37/32, H05H 1/46

(54) **VORRICHTUNG ZUR ERZEUGUNG VON LEISTUNGSFÄHIGEN MIKROWELLENPLASMEN**
DEVICE FOR GENERATING POWERFUL MICROWAVE PLASMAS
DISPOSITIF POUR LA PRODUCTION DE PLASMAS HYPERFREQUENCE PUISSANTS

(30) Priorität: 08.03.1996 DE 19608949
(43) Veröffentlichungstag der Anmeldung: 23.12.1998
(73) Patentinhaber: Spitzl, Ralf, 53639 Königswinter (DE)
(72) Erfinder: Spitzl, Ralf, 53639 Königswinter (DE); Aschermann, Benedikt, 42111 Wuppertal (DE)
(74) Vertreter: Flaccus, Rolf-Dieter, Dr.
(86) Internationale Anmeldenummer: PCT/EP1997/001114
(87) Internationale Veröffentlichungsnummer: WO 1997/033299

(56) Entgegenhaltungen:
- EP-A- 0 564 359
- FR-A- 2 668 676
- US-A- 3 577 207
- US-A- 4 559 099
- US-A- 5 487 875

## Beschreibung

Mikrowellenplasmen werden in technischen Bereichen wie z.B. der Herstellung bzw. Bearbeitung von Bauteilen, in der Mikroelektronik, bei der Beschichtung, in der Gaszersetzung, der Stoffsynthese oder der Materialreinigung eingesetzt.

In den vorrichtungen werden die Mikrowellen in die Plasmakammer mit dem ggf. darin befindlichen Rezipienten d.h. Nutzraum, aus einem Mikrowellenerzeuger ggf. über eine Zuleitung zu einem Hohlleiterresonator um die Plasmakammer mittels Koppelstellen geleitet. Üblich sind besonders Ringresonatoren, d.h. ringförmig ausgebildete Hohlleiterresonatoren mit geringer Länge entlang ihrer Achse, verglichen mit dem relativ großen Durchmesser des Querschnitts des Resonatorrings. Häufig hat die Achse des Ringresonators und die Achse des in diesem Falle z.B. als Rohr ausgebildeten Plasmakammer die gleiche oder eine gemeinsame z-Achse.

Nach DE 196 00 223.0 - 33 hat der Resonatorring einen rechteckigen Querschnitt und die Koppelstellen liegen z.B. als Schlitze in der kurzen Querschnittsseite. Solche Vorrichtungen zur Erzeugung von Mikrowellenplasmen besitzen gute Wirksamkeit. Es besteht jedoch Bedarf nach homogeneren und leistungsfähigeren Plasmakammern und einfacher gestalteten Vorrichtung.

Gegenstand der Erfindung ist eine Vorrichtung zur Erzeugung von Mikrowellenplasmen, deren Resonator als Koaxial-Resonator mit Innen- und Außenleiter ausgebildet ist, gemäß Anspruch 1. Soweit Leiter ganz oder teilweise die Innen- und Außenabgrenzung des Resonators bilden, ist deren Form und die Form der Leiter beliebig. Beide Leiter haben bevorzugt eine ähnliche, gleichartige, oder gleiche Achsenrichtung oder eine gemeinsame Achse z. Vakuum ist bei Betrieb der Vorrichtung überraschend nicht unbedingt notwendig.

Eine Vorrichtung gemäß Anspruch 1, Oberbegriff, ist bekannt aus EP-A-564359.

Die Fertigung erfolgt aus Hohlprofilen, vorzugsweise z.B. Walzprofilen, gestreckter Art, die als koaxialer Leiter ineinander angeordnet sind und an den Enden abgeschlossen oder offen sein können. Einfach gestaltbare Beispiele sind zwei Rohre bzw. Zylinder beliebiger, auch eckiger Grundfläche, die ineinander angeordnet sind. Ein Draht oder massiver Zylinder als Innenleiter ist bevorzugt, wenn nur über den Außenleiter gekoppelt wird.

Der Resonator kann im wesentlichen die gleiche Achse in z-Richtung wie die Plasmakammer besitzen und Resonator und Plasmakammer können entlang der z-Richtung gleich lang oder nicht gleich lang ausgebildet sein.

Alle Bauteile können auch mehrfach in der Apparatur enthalten sein.

Die Erfindung geht also ab vom schmal ausgebildeten Resonatorring mit verschiedenem Querschnitts, der die Plasmakammer, die z.B. als Resonator ausgebildet ist, wie ein Fingerring den Finger einer Hand umfaßt. Statt dessen ist der Koaxial-Resonator erfindungsgemäß langgestreckt und kann z.B. als Hülle wie der Raum einer Fingerhülle des Handschuhs um den Finger auf im wesentlichen ganzer Länge in Richtung der z-Achse ausgebildet sein. Plasmakammer und Resonator sind erfindungsgemäß nicht an eine bestimmte Form der Hohlkörper gebunden. Der Innen- und Außenleiter des Koaxial-Resonators besitzt sehr bevorzugt im wesentlichen mit ihrer langen oder längsten Achse, genannt z-Achse, im wesentlichen die gleiche Richtung. Bevorzugt ist die gleiche Richtung der Achsen von Kammer und Koaxial-Resonator, eine gemeinsame oder parallele Achse, jedoch ist auch ein geringer Winkel oder eine Verkippung bis zu 90° zwischen den Achsen beider Bauteile möglich.

Koaxiale Leiter, aus flexiblen Metallschläuchen hergestellt, z.B. als Wendelstreifen oder ineinander greifenden Ringen sind möglich, wobei zwei ineinander angeordnete Schläuche oder ein Schlauch gewandelt um z.B. eine rohrförmige oder eiförmige Kammer als der eine Leiter, den Resonator bilden. Die Wand der Plasmakammer kann der eine Leiter sein, wobei die Form der Plasmakammer beliebig ist, aber stetige Ausbildung als Rohr, Kugel oder Zylinder bevorzugt sind.

In allen Fällen können Kammer und Resonator gleich oder ungleich lang sein, wobei eine oder auch mehrere Kammern, ein oder mehrere Koaxial-Resonatoren oder geteilte Kammern oder Koaxial-Resonatoren z.B. senkrecht zur Vorzugsrichtung ausgebildet sein können.

Koppelstellen als z.B. Antennen oder bevorzugt als Schlitze bzw. Aussparungen können an den Wandungen des Koaxial-Resonators, d.h. an den mit der Kammer gemeinsamen Wänden, in beliebiger Zahl, bevorzugt in der für die jeweils gewählte Plasmamode benötigten Zahl, Geometrie und Anordnung angeordnet sein.

Koppelstellen von kleinen Dimensionen stören die Resonanz im Koaxial-Resonator nicht wesentlich. Solche Koppelstellen und eine größere Anzahl von Koppelstellen ermöglichen die vielfach bevorzugte homogene Ausbildung des Plasmas in der Plasmakammer und eine Resonanz in der Kammer im Falle geeigneter Dimensionen.

Die Mikrowellenquelle kann direkt, über ggf. geregelte Zuleitung oder über einen weiteren Resonator an einer beliebigen Stelle des Koaxial-Resonators, auch an der Innenabgrenzung, angeordnet sein und in ein oder mehrere Plasmakammern einkoppeln. Die Plasmakammer wie auch der Koaxialresonator kann ganz oder auch teilweise ein dielektrisches Material wie z.B. Keramik, Quarzglas oder Teflon enthalten.

Gemäß dieser Erfindung besteht nicht mehr die Notwendigkeit, die Kammer nur innerhalb des Resonators anzuordnen. Eine im Innenleiter ganz oder teilweise angeordnete Innenkammer ist möglich, auch eine Außenkammer und ggf. sowohl eine oder mehrere Außenkammern und ein oder mehrere Innenkammern mit jeweils darin angeordnetem Nutzraum bzw. Rezipienten mit dielektrischen Wandungen von beliebiger Gestalt.

Der Koaxial-Resonator der Erfindung ermöglicht somit eine Vielfalt der Gestalt und Ausbildung. Die Plasmakammer kann ein zusätzlicher Resonator oder dessen Teil sein. Bevorzugt ist hierbei die Ausbildung der Plasmakammer als zylinderresonator und die damit verbundene Ausbildung bestimmter Moden. Mehrere Zuleitungen der Mikrowellen an eine oder mehrere Koaxialresonatoren können ausgebildet sein.

Für die Moden der jeweiligen Art sind bestimmte apparative und geometrische Ausbildungen der Vorrichtung besonders geeignet. Die bevorzugten Koaxialmoden TEM- oder TMₙ₁ bildet sich im Koaxial-Resonator optimal zwischen zwei bevorzugt zylindrischen elektrisch leitenden Rohren von unterschiedlichem Durchmesser. Darin sind auch beliebige TEₙₘ oder TMₙₘ Feldverteilungen möglich. Die Länge beider Rohre beträgt bevorzugt ein vielfaches der halben Leitungs-Wellenlänge der verwendeten Mikrowelle. An beiden Enden sind dann die Rohre elektrisch leitend begrenzt, z.B. durch eine Wand, gasdurchläßiges Gitter oder einen Kurzschlußschieber.

Der bzw. die Rezipienten, wie üblich aus dielektrischem Material, können gemäß der Erfindung großvolumig sein und bei Teilung verschiedenen Aufgaben dienen. Im Falle eines großräumigen außen angeordneten Rezipienten ist eine metallische Abschlußwand nicht zwingend erforderlich.

Permanentmagnete oder Spulenanordnungen z.B. nach Helmholz um das jeweils äußere Rohr oder die metallene Außenwand ermöglichen in der Kammer die Bedingungen für Elektronen Zyklotron Resonanz Plasmen. Eine Anordnung von Magneten im Innenleiter des Koaxial-Resonators ist ebenso möglich.

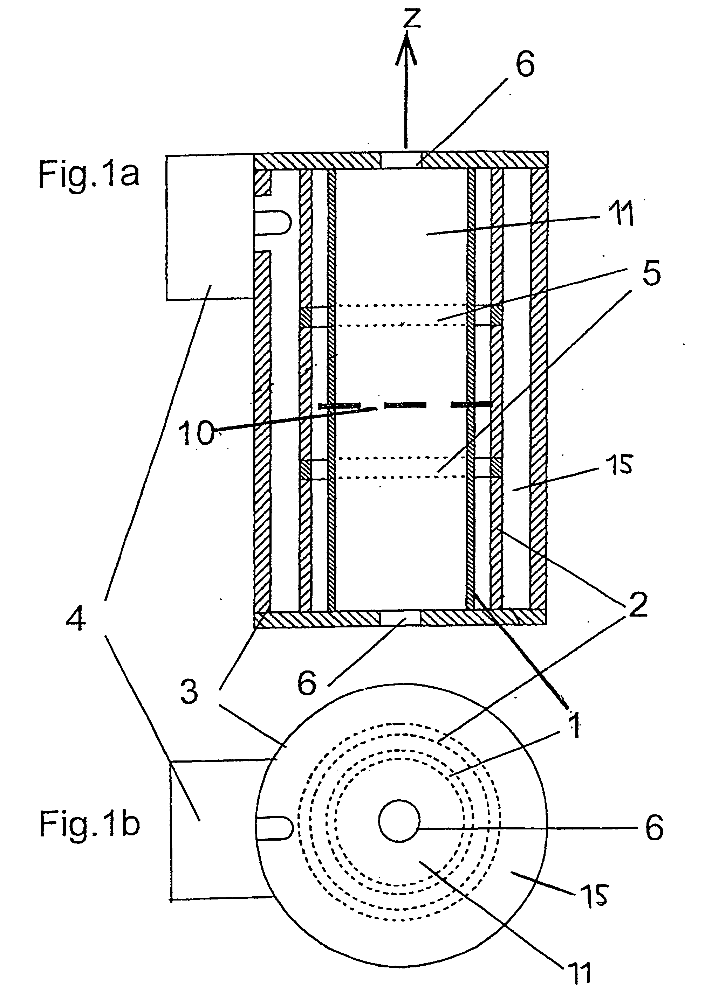

Fig.1 zeigt in Fig.1a einen Schnitt durch eine Vorrichtung entlang der z-Achse, Fig. 1b die dazugehörige Aufsicht. Dargestellt ist eine Vorrichtung mit Innenwand 2 und Außenwand 3 eines rohrförmigen Koaxial-Resonators mit Mikrowellenquelle 4, die in den Resonator zwischen 2 und 3 einkoppelt, und Rezipienten 1. In Fig.1 sind zwei Koppelschlitze 5 als umlaufende Schlitze in der Innenwand 2 ausgeführt; diese stehen somit senkrecht zur z-Achse der Vorrichtung. Koaxial-Resonator und innenliegende Plasmakammer, die als Zylinderresonator ausgeführt ist, zeigen in diesem Ausführungsbeispiel gleiche Länge in z-Richtung. 10 ist ein optionales z.B. metallisches Gitter, welches die Plasmakammer in zwei Kammern aufteilt.

Im oberen bzw. unteren Abschluß der Plasmakammer sind Öffnungen 6 für die Zu- bzw. Abfuhr von z.B. Prozessgasen eingezeichnet.

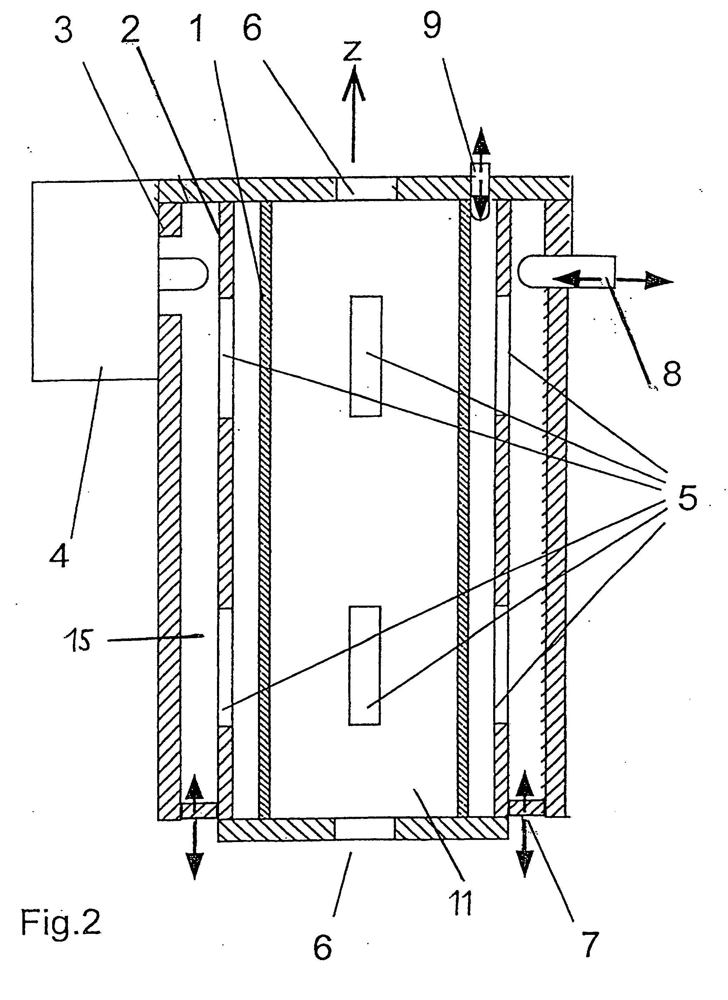

Fig.2 zeigt eine ähnliche Vorrichtung wie Fig.1, jedoch sind hier die Koppelstellen 5 als Längsschlitze in der Wand des inneren Koaxialleiters angeordnet und verlaufen somit parallel zur z-Achse der Vorrichtung. Weiterhin sind in Fig. 2 einige Abstimmöglichkeiten von Koaxial-Resonator und Plasmakammer exemplarisch aufgeführt. Der Abschlußschieber 7 dient zur Abstimmung des Koaxial-Resonators. Der Abstimm-Stift bzw. Schraube 8 dient dem gleichen Zweck. Die Lage und Anzahl solcher Abstimmelemente kann nach Bedarf variiert werden. Der Abstimm-Stift 9 zeigt eine Abstimmöglichkeit für die Plasmakammer. Eine ähnliche Funktion hat auch ein hier nicht gezeigter Abschlußschieber, der die Länge der Plasmakammer verändert. Die Pfeile in der Figur geben die Bewegungsrichtung der Abstimmelemente an.

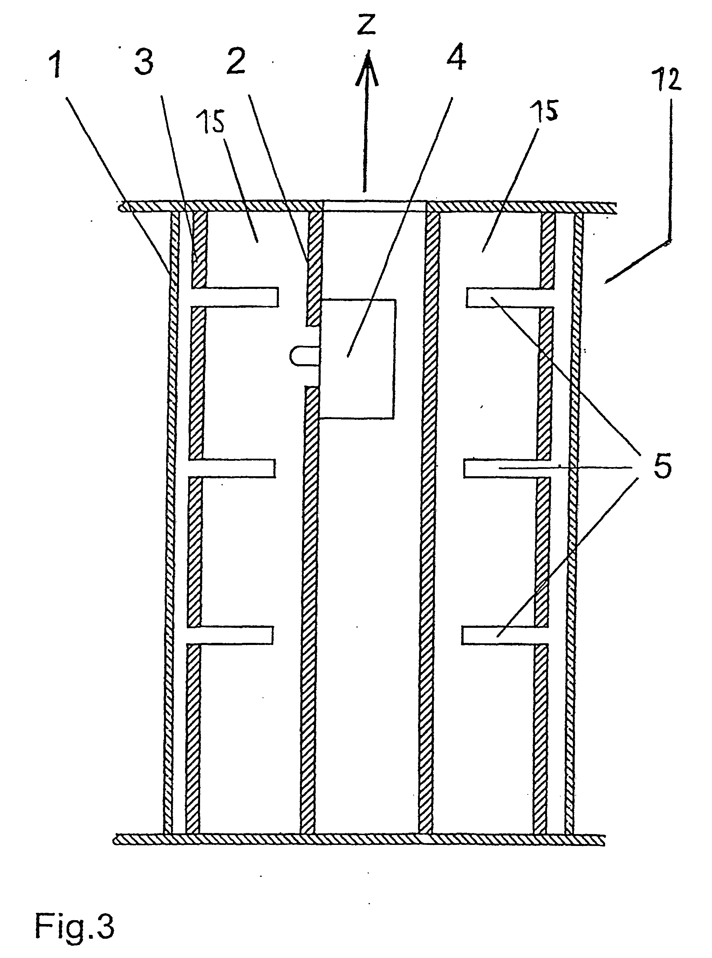

Fig. 3 zeigt einen Ausschnitt einer Vorrichtung mit außenliegender, hier nicht vollständig dargestellter Plasmakammer. Der Mikrowellenerzeuger 4 ist im Inneren des Innenleiters 2 des Koaxial-Resonators angebracht. Die Koppelstellen 5 sind als drei azimutale, teilweise umlaufende Koppelschlitze in der Außenwand des Koaxial-Resonators ausgeführt.

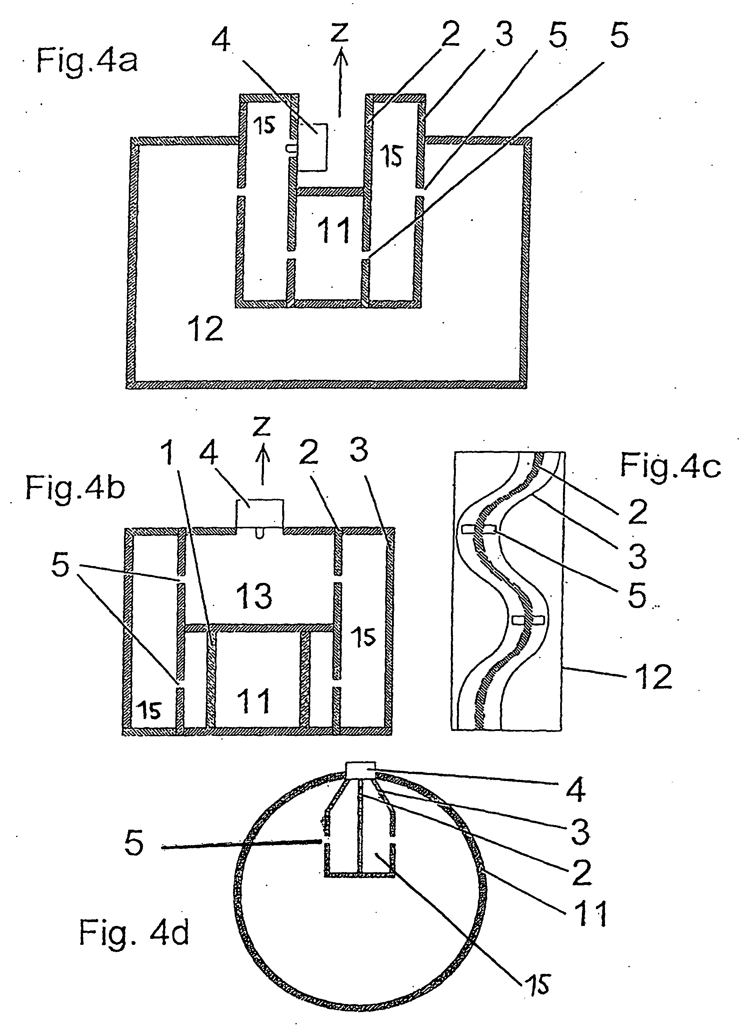

In Fig.4 sind weitere Ausfühungsbeispiele der Vorrichtung skizziert, wobei in Fig. 4a ein Schnitt durch eine Vorrichtung mit sowohl innerer Plasmakammer 11 als auch aussenliegender Kammer 12 dargestellt ist. Bei Bedarf können die Plasmakammern 11, 12 mit Rezipienten ausgestattet werden.

Fig. 4b zeigt einen Schnitt durch eine Vorrichtung, bei der die Mikrowelle in einen Zylinderresonator 13 direkt eingekoppelt wird und dieser Resonator über einen umlaufenden azimuthalen Schlitze mit dem Koaxial-Resonator gekoppelt ist. Die Einkopplung in die als weiterer Zylinderresonator ausgebildete Plasmakammer 11 mit Rezipient 1 erfolgt über weitere Koppelschlitze.

Fig. 4c zeigt einen Schnitt durch eine Vorrichtung, worin ein z.B. schraubenförmig gewendelter Koaxial-Resonator mit Außenleiter 3 und gleichartig gewendeltem z.B. als Draht ausgebildeter Innenleiter 2 in einer zylindrischen Kammer 12 liegt. Eine Bauform, bei der der Koaxial-Resonator in gewendelter bzw gewickelter Form mit dem Aussenleiter eine Kammer ganz oder teilweise umschließt, d.h wie z.B. eine Band oder eine Schnur eine Kammer umwickelt ist ebenfalls möglich.

Fig. 4d zeigt einen Schnitt durch eine Vorrichtung, mit kugelförmiger Plasmakammer 11. Die Antenne des Mikrowellenerzeugers 4 ist direkt mit dem Innenleiter 2 des Koaxial-Resonators verbunden. Der Aussenleiter 3 ist zum Mikrowellenerzeuger 4 hin kegelförmig verjüngt. Über einen azimutalen Koppelschlitz 5 wird die Mikrowellenleistung in die Plasmakammer gekoppelt.

## Patentansprüche

1. Vorrichtung zur Erzeugung von Mikrowellenplasmen, die mindestens einen Mikrowellenerzeuger (4), mindestens einen zuleitenden Resonator (15), mindestens eine Plasmakammer (11,12) und Koppelstellen (5) zwischen zuleitendem Resonator (15) und Plasmakammer (11,12) umfaßt, **dadurch gekennzeichnet, daß** Außenabgrenzung (3) und Innenabgrenzung (2) des zuleitenden Resonators (15) als Außen- und Innenleiter eines Koaxialresonators ausgebildet sind.

2. Vorrichtung nach Anspruch 1, **dadurch gekennzeichnet, daß** sie einen oder mehrere Rezipienten (1) mit dielektrischen Wandungen aufweist.

3. Vorrichtung nach Anspruch 1 oder 2, **dadurch gekennzeichnet, daß** die Plasmakammer (11) vom Resonator (15) ganz oder teilweise umfaßt ist.

4. Vorrichtung nach Anspruch 1 oder 2, **dadurch gekennzeichnet, daß** der Resonator (15) von der Plasmakammer (12) ganz oder teilweise umfaßt ist.

5. Vorrichtung nach Anspruch 1 oder 2, **dadurch gekennzeichnet, daß** innerhalb und/oder außerhalb des Resonators (15) eine oder mehrere Kammern angeordnet sind, bzw. daß die Plasmakammer (11,12) geteilt ist.

6. Vorrichtung nach einem der vorangehenden Ansprüche, **dadurch gekennzeichnet, daß** der Koaxial-Resonator (15) und die Plasmakammer (11,12) die gleiche Vorzugsrichtung aufweisen und gleich lang oder verschieden lang ausgebildet sind.

7. Vorrichtung nach einem der vorangehenden Ansprüche, **dadurch gekennzeichnet, daß** die Koppelstellen (5) für die Ein- bzw. Auskopplung der Mikrowellen von dem Resonator (15) in bzw. an den Wandungen des Koaxial-Resonators (15) bzw. in oder an der gemeinsamen Wand von Kammer (11,12) und Resonator (15) angeordnet sind.

8. Vorrichtung nach einem der vorangehenden Ansprüche, **dadurch gekennzeichnet, daß** die Koppelstellen (5) Stabantennen oder/und Schlaufen oder/und Schlitze oder/und Aussparungen sind.

## Claims

1. Device for the production of microwave plasmas, having at least one microwave generator (4), at least one feeding resonator (15), at least one plasma chamber (11, 12), and coupling points (5) between the feeding resonator (15) and the plasma chamber (11, 12), **characterized in that** the outer boundary (3) and inner boundary (2) of the feeding resonator (15) are designed as the outer and inner conductors of a coaxial resonator.

2. Device according to claim 1, **characterized in that** it has one or more containers (1) with dielectric walls.

3. Device according to Claim 1 or 2, **characterized in that** the plasma chamber (11) is fully or partially surrounded by the resonator (15).

4. Device according to Claim 1 or 2, **characterized in that** the resonator (15) is fully or partially surrounded by the plasma chamber (12).

5. Device according to Claim 1 or 2, **characterized in that** one or more chambers are arranged inside and/or outside the resonator (15), or the plasma chamber (11, 12) is divided.

6. Device according to any one of the preceding claims, **characterized in that** the coaxial resonator (15) and the plasma chamber (11, 12) have the same preferential direction and are designed with equal length or different length.

7. Device according to one of the preceding claims, **characterized in that** the coupling points (5) for coupling the microwaves into or out of the resonator (15) are arranged in or on the walls of the coaxial resonator (15), or in or on the common wall of the chamber (11, 12) and resonator (15).

8. Device according to one of the preceding claims, **characterized in that** the coupling points (5) are rod antennas and/or loops and/or slots and/or gaps.

## Revendications

1. Dispositif pour la production de plasmas hyperfréquence, qui comprend au moins un générateur d'hyperfréquence (4), au moins un résonateur d'alimentation (15), au moins une chambre à plasma (11, 12) et des points de couplage (5) intercalés entre le résonateur d'alimentation (15) et la chambre à plasma (11, 12), **caractérisé en ce que** la délimitation extérieure (3) et intérieure (2) du résonateur d'alimentation (15) sont conçues comme conducteur extérieur et intérieur d'un résonateur coaxial.

2. Dispositif selon la revendication 1, **caractérisé en ce qu'**il présente un ou plusieurs récipients (1) avec des parois diélectriques.

3. Dispositif selon la revendication 1 ou 2, **caractérisé en ce que** la chambre à plasma (11) est entourée en totalité ou en partie par le résonateur (15).

4. Dispositif selon la revendication 1 ou 2, **caractérisé en ce que** le résonateur (15) est entouré en totalité ou en partie par la chambre à plasma (12).

5. Dispositif selon la revendication 1 ou 2, **caractérisé en ce que** à l'intérieur et/ou à l'extérieur du résonateur (15) une ou plusieurs chambres sont disposées, resp. **en ce que** la chambre à plasma (11, 12) est divisée.

6. Dispositif selon l'une des revendications précédentes, **caractérisé en ce que** le résonateur coaxial (15) et la chambre à plasma (11, 12) présentent la même direction préférentielle et sont conçus de même longueur ou de longueur différente.

7. Dispositif selon l'une des revendications précédentes, **caractérisé en ce que** les points de couplage (5) pour le couplage resp. découplage des hyperfréquences du résonateur (15) sont disposés dans resp. sur les parois du résonateur coaxial (15) resp. dans ou sur la paroi commune de la chambre (11, 12) et du résonateur (15).

8. Dispositif selon l'une des revendications précédentes, **caractérisé en ce que** les points de couplage (5) sont des antennes tige ou/et des boucles ou/et des fentes oulet des évidements.
